# EUROPEAN PATENT APPLICATION

(11) **EP 4 502 230 A1**
(43) Date of publication of application: **05.02.2025**
(21) Application number: 22935596.1
(22) Date of filing: 26.09.2022
(51) Int. Cl.: C23C 16/455, H01L 21/31

(54) **SUBSTRATE TREATMENT DEVICE, GAS SUPPLY SYSTEM, SUBSTRATE TREATMENT METHOD, PRODUCTION METHOD FOR SEMICONDUCTOR DEVICE, AND PROGRAM**

(30) Priority: 29.03.2022 JP 2022053818
(71) Applicant: Kokusai Electric Corporation, Tokyo 101-0045 (JP)
(72) Inventor: GOSHIMA Kentaro, Toyama-shi, Toyama 939-2393 (JP); ABURATANI Yukinori, Toyama-shi, Toyama 939-2393 (JP); YAMAMOTO Kaoru, Toyama-shi, Toyama 939-2393 (JP)
(74) Representative: Verscht, Thomas Kurt Albert
(86) International application number: PCT/JP2022/035796
(87) International publication number: WO 2023/188465

(57) **Abstract**

Provided is a technique capable of stably controlling the flow rate of a gas species, the flow rate of which is difficult to control in MFC. Thus, this substrate treatment device comprises: a treatment container for housing a substrate; a first gas pipe that supplies a treatment gas to the treatment container; a flow rate measurement unit that is provided to the first gas pipe, and that measures the flow rate of the treatment gas flowing inside the first gas pipe; a second gas pipe that is connected to the first gas pipe, and that supplies a first inert gas to a tank that retains a raw material for the treatment gas; a first flow rate adjustment unit that is provided to the second gas pipe, and that adjusts the flow rate of the first inert gas; a first heating unit that adjusts the temperature of the first inert gas; and a control unit that is configured to be capable of controlling the first flow rate adjustment unit and the first heating unit on the basis of flow rate data of the treatment gas measured by the flow rate measurement unit, so as to perform a process of supplying, to the substrate in the treatment container, the treatment gas for which at least one of the flow rate of the first inert gas and the temperature of the first inert gas is adjusted such that the flow rate of the treatment gas is a predetermined flow rate.

## Description

### [Technical Field]

The present disclosure relates to a substrate processing apparatus, a gas supply system, a substrate processing method, a method of manufacturing a semiconductor device and a program.

### [Related Art]

A gas supply system using a mass flow controller (MFC) may be used to control a flow rate of a gas supplied to a reaction chamber of a substrate processing apparatus. For example, according to Patent Document 1, such a gas supply system is disclosed.

### [Related Art Document]

### [Patent Document]

Patent Document 1: Japanese Patent Laid-Open No. 2017-045880.

### [Disclosure]

### [Technical Problem]

According to the present disclosure, there is provided a technique capable of stably controlling a flow rate of a gas even when using a gas whose flow rate is difficult to control with a mass flow controller (MFC).

### [Technical Solution]

According to an embodiment of the present disclosure, there is provided a technique that includes: a process vessel in which a substrate is accommodated; a first gas pipe through which a process gas is supplied to the process vessel; a flow rate measurer provided at the first gas pipe and configured to measure a flow rate of the process gas flowing through the first gas pipe; a second gas pipe connected to the first gas pipe and through which a first inert gas is supplied to a tank configured to store a source material of the process gas; a first flow rate regulator provided at the second gas pipe and configured to adjust a flow rate of the first inert gas; a first heater configured to adjust a temperature of the first inert gas; and a controller configured to be capable of controlling the first flow rate regulator and the first heater to supply the process gas to the substrate in the process vessel by adjusting one or both of the flow rate of the first inert gas and the temperature of the first inert gas such that the flow rate of the process gas is adjusted to be a predetermined flow rate based on flow rate data of the process gas measured by the flow rate measurer.

### [Advantageous Effects]

According to the configurations described above, it is possible to stably control a flow rate of a gas even when using a gas whose flow rate is difficult to control with an MFC.

### [Brief Description of Drawings]

FIG. 1 is a diagram schematically illustrating a vertical cross-section of a vertical type process furnace of a substrate processing apparatus according to one or more embodiments of the present disclosure.
FIG. 2 is a diagram schematically illustrating a horizontal cross-section taken along a line A - A of the substrate processing apparatus shown in FIG. 1.
FIG. 3 is a diagram schematically illustrating a configuration of a gas supply system according to the embodiments of the present disclosure.
FIG. 4 is a block diagram schematically illustrating a configuration of a controller and related components of the substrate processing apparatus according to the embodiments of the present disclosure.
FIG. 5 is a flow chart schematically illustrating a substrate processing according to the embodiments of the present disclosure.

### [Detailed Description]

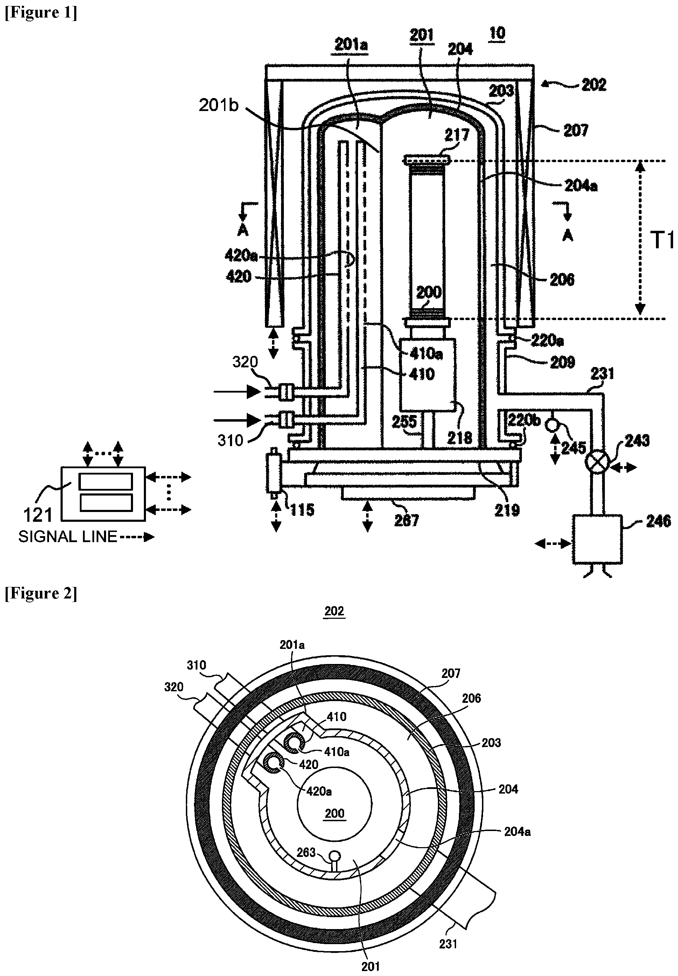

Hereinafter, one or more embodiments of the technique of the present disclosure will be described in detail mainly with reference to FIGS. 1 through 5. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match.

### (1) Configuration of Substrate Processing Apparatus

A substrate processing apparatus 10 according to the present embodiments includes a process furnace 202 provided with a heater 207 serving as a heating structure (which is a heating device or a heating system). The heater 207 is of a cylindrical shape, and is vertically installed while being supported by a heater base (not shown) serving as a support plate.

### <Outer Tube (Outer Cylinder, Outer Pipe) 203>

An outer tube (also referred to as an "outer cylinder" or an "outer pipe") 203 constituting a reaction vessel (which is a process vessel) is provided in an inner side of the heater 207 to be aligned in a manner concentric with the heater 207. For example, the outer tube 203 is made of a heat resistant material such as quartz (SiO₂) and silicon carbide (SiC). The outer tube 203 is of a cylindrical shape with a closed upper end and an open lower end. A manifold (which is an inlet flange) 209 is provided under the outer tube 203 to be aligned in a manner concentric with the outer tube 203. For example, the manifold 209 is made of a metal such as stainless steel (SUS). The manifold 209 is of a cylindrical shape with open upper and lower ends. An O-ring 220a serving as a seal is provided between the upper end of the manifold 209 and the outer tube 203. As the manifold 209 is supported by the heater base (not shown), the outer tube 203 is installed vertically.

### <Inner Tube (Inner Cylinder, Inner Pipe) 204>

An inner tube (also referred to as an "inner cylinder" or an "inner pipe") 204 constituting the reaction vessel is provided in an inner side of the outer tube 203. For example, the inner tube 204 is made of a heat resistant material such as quartz (SiO₂) and silicon carbide (SiC). The inner tube 204 is of a cylindrical shape with a closed upper end and an open lower end. The process vessel (reaction vessel) is constituted mainly by the outer tube 203, the inner tube 204 and the manifold 209. A process chamber 201 is provided in a hollow cylindrical portion of the process vessel (that is, an inside of the inner tube 204).

### <Substrate Support (Boat) 217>

The process chamber 201 is configured to be capable of accommodating a plurality of wafers 200 serving as a substrate in a horizontal orientation to be vertically arranged in a multistage manner by a boat 217 described later. Nozzles 410 and 420 (that is, a first nozzle 410 and a second nozzle 420) are installed in the process chamber 201 so as to penetrate a side wall of the manifold 209 and the inner tube 204. Gas supply pipes 310 and 320 serving as gas supply lines are connected to the nozzles 410 and 420, respectively. In a manner described above, for example, the two nozzles 410 and 420 and the two gas supply pipes 310 and 320 are provided at the substrate processing apparatus 10, and thereby it is possible to supply various gases into the process chamber 201 through the two nozzles 410 and 420 and the two gas supply pipes 310 and 320. However, the process furnace 202 of the present embodiments is not limited to the example described above.

### <Gas Supplier>

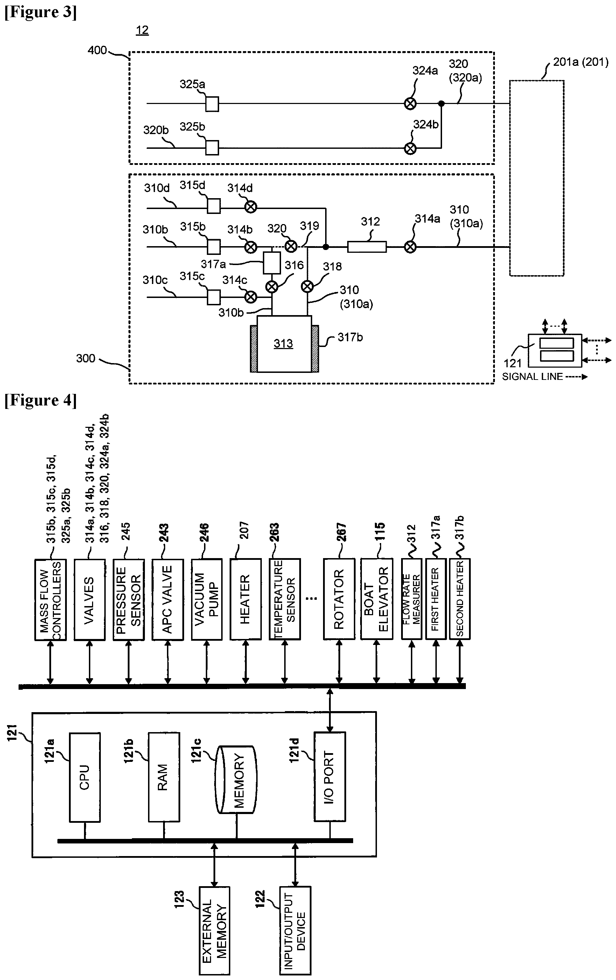

The gas supply pipes 310 and 320 are connected to a gas supply system shown in FIG. 3. The gas supply system will be described in detail later.

The nozzles 410 and 420 are connected to front ends (tips) of the gas supply pipes 310 and 320, respectively. Each of the nozzles 410 and 420 may be configured as an L-shaped nozzle. Horizontal portions of the nozzles 410 and 420 are installed so as to penetrate the side wall of the manifold 209 and the inner tube 204. Vertical portions of the nozzles 410 and 420 are installed in a preliminary chamber 201a of a channel shape (a groove shape) protruding outward in a radial direction of the inner tube 204 and extending in a vertical direction. That is, the vertical portions of the nozzles 410 and 420 are installed in the preliminary chamber 201a to extend toward the upper end of the inner tube 204 (in an upward direction in which the wafers 200 are arranged) and along an inner wall of the inner tube 204. In addition, the nozzles 410 and 420 are arranged outside an opening 201b of the preliminary chamber 201a.

The nozzles 410 and 420 extend from a lower region of the process chamber 201 to an upper region of the process chamber 201. The nozzles 410 and 420 are provided with a plurality of gas supply holes 410a and a plurality of gas supply holes 420a facing the wafers 200, respectively. Thereby, a gas such as a process gas can be supplied to the wafers 200 through each of the gas supply holes (openings) 410a of the nozzle 410 and each of the gas supply holes (openings) 420a of the nozzle 420.

The gas supply holes 410a are provided from a lower portion to an upper portion of the inner tube 204. An opening area of each of the gas supply holes 410a is the same, and each of the gas supply holes 410a is provided at the same pitch. However, the gas supply holes 410a are not limited thereto. For example, the opening area of each of the gas supply holes 410a may gradually increase from the lower portion to the upper portion of the inner tube 204. Thereby, it is possible to further uniformize a flow rate of the gas supplied through the gas supply holes 410a.

The gas supply holes 420a are provided from the lower portion to the upper portion of the inner tube 204. An opening area of each of the gas supply holes 420a is the same, and each of the gas supply holes 420a is provided at the same pitch. However, the gas supply holes 420a are not limited thereto. For example, the opening area of each of the gas supply holes 420a may gradually increase from the lower portion to the upper portion of the inner tube 204. Thereby, it is possible to further uniformize a flow rate of the gas supplied through the gas supply holes 420a.

The gas supply holes 410a of the nozzle 410 and the gas supply holes 420a of the nozzle 420 are provided from a lower portion to an upper portion of the boat 217 described later. Therefore, the process gas supplied into the process chamber 201 through the gas supply holes 410a of the nozzle 410 and the gas supply holes 420a of the nozzle 420 is supplied onto the wafers 200 accommodated in the boat 217 from the lower portion to the upper portion thereof, that is, an entirety of the wafers 200 accommodated in the boat 217. It is preferable that the nozzles 410 and 420 extend from the lower region to the upper region of the process chamber 201. However, the nozzles 410 and 420 may extend only to the vicinity of a ceiling of the boat 217.

A source gas containing a first metal element (also referred to as a "first metal-containing gas" or a "first source gas") is supplied into the process chamber 201 through the gas supply pipe 310 and the nozzle 410. The source gas serves as one of process gases.

A reactive gas serving as one of the process gases is supplied into the process chamber 201 through the gas supply pipe 320 and the nozzle 420.

According to the present embodiments, the source gas (which is a metal-containing gas) is supplied into the process chamber 201 through the gas supply holes 410a of the nozzle 410 and the reactive gas is supplied into the process chamber 201 through the gas supply holes 420a of the nozzle 420. Thereby, the source gas (that is, the metal-containing gas) and the reactive gas are supplied to a surface of the wafer 200 to form a metal-containing film on the surface of the wafer 200.

Further, an inert gas can be supplied into the process chamber 201 through the nozzles 410 and 420. Hereinafter, the present embodiments will be described by way of an example in which nitrogen (N₂) gas is used as the inert gas. However, for example, instead of or in addition to the N₂ gas, a rare gas such as argon (Ar) gas, helium (He) gas, neon (Ne) gas and xenon (Xe) gas may be used as the inert gas.

According to the present embodiments, the gas is supplied into a vertically long annular space (which is defined by the inner wall of the inner tube 204 and edges (peripheries) of the wafers 200) through the nozzles 410 and 420 provided in the preliminary chamber 201a. The gas is ejected into the inner tube 204 through the gas supply holes 410a of the nozzle 410 and the gas supply holes 420a of the nozzle 420 facing the wafers 200. Specifically, gases such as the source gas are ejected into the inner tube 204 in a direction parallel to surfaces of the wafers 200 through the gas supply holes 410a of the nozzle 410 and the gas supply holes 420a of the nozzle 420, respectively.

### <Exhauster>

An exhaust hole (which is an exhaust port) 204a is a through-hole facing the nozzles 410 and 420, and is provided at a side wall of the inner tube 204. For example, the exhaust hole 204a may be provided at a location 180 ° opposite to the preliminary chamber 201a, and the exhaust hole 204a may be of a narrow slit-shaped through-hole elongating vertically. Therefore, the gases (which are supplied into the process chamber 201 through the gas supply holes 410a of the nozzle 410 and the gas supply holes 420a of the nozzle 420) are supplied (or flow) over the surfaces of the wafers 200. The gases (residual gases) that have flowed over the surfaces of the wafers 200 are exhausted through the exhaust hole 204a into an exhaust path 206 constituted by a gap provided between the inner tube 204 and the outer tube 203. The gases flowing in the exhaust path 206 are supplied into an exhaust pipe 231, and are then discharged (exhausted) out of the process furnace 202. For example, an exhauster (which is an exhaust structure or an exhaust system) is constituted by at least the exhaust pipe 231.

The exhaust hole 204a is provided to face the wafers 200 (preferably, to face the boat 217 from the upper portion to the lower portion thereof). The gases supplied in the vicinity of the wafers 200 in the process chamber 201 through the gas supply holes 410a and the gas supply holes 420a are supplied (or flow) in the horizontal direction (that is, along a direction parallel to the surfaces of the wafers 200), and then are exhausted through the exhaust hole 204a into the exhaust path 206. That is, the gases (residual gases) remaining in the process chamber 201 are exhausted along the direction parallel to the surfaces (main surfaces) of the wafers 200 through the exhaust hole 204a. Further, the exhaust hole 204a is not limited to the slit-shaped through-hole. For example, the exhaust hole 204a may be configured as a plurality of holes.

The exhaust pipe 231 through which an inner atmosphere of the process chamber 201 is exhausted is installed at the manifold 209. A pressure sensor 245 serving as a pressure detector (pressure detecting structure) configured to detect an inner pressure of the process chamber 201, an APC (Automatic Pressure Controller) valve 243 and a vacuum pump 246 serving as a vacuum exhaust apparatus are sequentially installed at the exhaust pipe 231 in this order from an upstream side to a downstream side of the exhaust pipe 231 in a gas flow direction. With the vacuum pump 246 in operation, the APC valve 243 may be opened or closed to perform a vacuum exhaust of the process chamber 201 or stop the vacuum exhaust. Further, with the vacuum pump 246 in operation, an opening degree of the APC valve 243 may be adjusted in order to adjust the inner pressure of the process chamber 201. The exhauster (that is, an exhaust line) is constituted mainly by the exhaust hole 204a, the exhaust path 206, the exhaust pipe 231, the APC valve 243 and the pressure sensor 245. In addition, the exhauster may further include the vacuum pump 246.

As shown in FIG. 1, a seal cap 219 serving as a furnace opening lid capable of airtightly sealing a lower end opening of the manifold 209 may be provided under the manifold 209. The seal cap 219 is in contact with the lower end of the manifold 209 from thereunder. For example, the seal cap 219 is made of a metal such as SUS, and is of a disk shape. An O-ring 220b serving as a seal is provided on an upper surface of the seal cap 219 so as to be in contact with the lower end of the manifold 209. A rotator 267 (which is a rotating structure) configured to rotate the boat 217 accommodating the wafers 200 is provided at the seal cap 219 in a manner opposite to the process chamber 201. A rotating shaft 255 of the rotator 267 is connected to the boat 217 through the seal cap 219. As the rotator 267 rotates the boat 217, the wafers 200 are rotated. The seal cap 219 may be elevated or lowered in the vertical direction by a boat elevator 115 serving as an elevating structure vertically provided outside the outer tube 203. When the seal cap 219 is elevated or lowered in the vertical direction by the boat elevator 115, the boat 217 may be transferred (loaded) into the process chamber 201 or transferred (unloaded) out of the process chamber 201. The boat elevator 115 serves as a transfer device (which is a transfer structure) capable of loading the boat 217 and the wafers 200 accommodated in the boat 217 into the process chamber 201 and capable of unloading the boat 217 and the wafers 200 accommodated in the boat 217 out of the process chamber 201.

The boat 217 serving as a substrate support is configured to accommodate (or support) the wafers 200 (for example, 25 to 200 wafers) while the wafers 200 are horizontally oriented with their centers aligned with one another with a predetermined interval therebetween in a multistage manner. For example, the boat 217 is made of a heat resistant material such as quartz and SiC. For example, a heat insulator (which is a heat insulating structure) 218 made of a heat resistant material such as quartz and SiC is provided under the boat 217. With such a configuration, it is possible to suppress a transmission of the heat from the heater 207 to the seal cap 219.

As shown in FIG. 2, a temperature sensor 263 serving as a temperature detector is installed in the inner tube 204. An amount of the current supplied (or applied) to the heater 207 is adjusted based on temperature information detected by the temperature sensor 263 such that a desired temperature distribution of an inner temperature of the process chamber 201 can be obtained. Similar to the nozzles 410 and 420, the temperature sensor 263 is L-shaped, and is provided along the inner wall of the inner tube 204.

With such a configuration, a temperature of at least a region (area) (of the boat 217) supporting the wafers 200 is maintained uniform. There is a difference between the temperature of the region (also referred to as a "soaking region T1") whose temperature is uniform and a temperature of a region (area) (of the boat 217) provided below the soaking region T1. For example, the soaking region T1 may also be referred to as a "substrate processing region" or a "substrate processing area". A length of the substrate processing region in the vertical direction is configured to be equal to or less than a length of the soaking region T1 in the vertical direction. In addition, the substrate processing region may refer to locations in the vertical direction of the boat 217 where the wafers 200 are supported (mounted or placed). In the present embodiments, the term "wafer" may refer to at least one among a product wafer, a dummy wafer and a fill dummy wafer. Further, the term "substrate processing region" may refer to a region in the boat 217 where the wafers 200 are accommodated. That is, the substrate processing region may also be referred to as a "substrate retaining region" or a "substrate retaining area".

As shown in FIG. 4, a controller 121 serving as a control device (or a control structure) is constituted by a computer including a CPU (Central Processing Unit) 121a, a RAM (Random Access Memory) 121b, a memory 121c and an I/O port 121d. The RAM 121b, the memory 121c and the I/O port 121d may exchange data with the CPU 121a through an internal bus. For example, an input/output device 122 constituted by a component such as a touch panel is connected to the controller 121.

For example, the memory 121c is configured by a component such as a flash memory and a hard disk drive (HDD). For example, a control program configured to control operations of the substrate processing apparatus 10 or a process recipe containing information on procedures and conditions of a method of manufacturing a semiconductor device described later may be readably stored in the memory 121c. The process recipe is obtained by combining steps (or processes) of the method of manufacturing the semiconductor device described later such that the controller 121 can execute the steps to acquire a predetermined result, and functions as a program. Hereafter, the process recipe and the control program may be collectively or individually referred to as a "program". Thus, in the present specification, the term "program" may refer to the process recipe alone, may refer to the control program alone, or may refer to a combination of the process recipe and the control program. The RAM 121b functions as a memory area (work area) where a program or data read by the CPU 121a is temporarily stored.

The I/O port 121d is connected to components such as mass flow controllers (MFCs) 315b, 315c, 315d, 325a and 325b, valves 314a, 314b, 314c, 314d, 316, 318, 321, 324a and 324b and the pressure sensor 245. In addition, the I/O port 121d is connected to the components such the APC valve 243, the vacuum pump 246, the heater 207, the temperature sensor 263, the rotator 267 and the boat elevator 115.

The CPU 121a is configured to read the control program from the memory 121c and execute the read control program. In addition, the CPU 121a is configured to read information such as a recipe such as the process recipe from the memory 121c in accordance with an operation command inputted from the input/output device 122. In accordance with the contents of the read recipe, the CPU 121a may be configured to control various operations such as flow rate adjusting operations for various gases by the MFCs 315b, 315c, 315d, 325a and 325b and opening and closing operations of the valves 314a, 314b, 314c, 314d, 316, 318, 320, 324a and 324b. Further, the CPU 121a may be configured to control various operations such as an opening and closing operation of the APC valve 243, a pressure adjusting operation by the APC valve 243 based on the pressure sensor 245, a temperature adjusting operation by the heater 207 based on the temperature sensor 263 and a start operation and a stop operation of the vacuum pump 246. Further, the CPU 121a may be configured to control various operations such as an operation of adjusting a rotation and a rotation speed of the boat 217 by the rotator 267, an elevating and lowering operation of the boat 217 by the boat elevator 115 and an operation of transferring and accommodating the wafer 200 into the boat 217.

The controller 121 may be embodied by installing the above-described program stored in an external memory 123 into a computer. For example, the external memory 123 may include a magnetic tape, a magnetic disk such as a flexible disk and a hard disk, an optical disk such as a CD and a DVD, a magneto-optical disk such as an MO and a semiconductor memory such as a USB memory and a memory card. The memory 121c or the external memory 123 may be embodied by a non-transitory computer readable recording medium. Hereafter, the memory 121c and the external memory 123 are collectively or individually referred to as a "recording medium". In the present specification, the term "recording medium" may refer to the memory 121c alone, may refer to the external memory 123 alone, and may refer to both of the memory 121c and the external memory 123. Instead of the external memory 123, a communication structure such as the Internet and a dedicated line may be used for providing the program to the computer.

### (2) Configuration of Gas Supply System

Subsequently, the gas supply system such as a source gas supply system according to the present embodiments will be described in detail. As shown in FIG. 3, a gas supply system 12 may include a source gas supply system 300 and a reactive gas supply system 400. First, the source gas supply system 300 will be described.

### <Source Gas Supply System>

### <Source Material>

In the present disclosure, the term "source material" refers to a material whose vapor pressure characteristics are such that a saturated vapor pressure thereof is within a range from 0.01 KPa to 100 KPa at a temperature within a range from 50 °C to 200 °C. More preferably, the term "source material" refers to a material that retains low vapor pressure characteristics such that a saturated vapor pressure thereof is within a range from 0.01 KPa to 5 KPa at a temperature within a range from 50 °C to 200 °C. Further, such a material that retains low vapor pressure characteristics may also be referred to as a "low vapor pressure material" (or a "low vapor pressure source material"). Further, in the present disclosure, the source material present in a tank 313 may be in a solid state, a liquid state or a gaseous state. Further, the source material present in the tank 313 may be a material which is in the solid state at a room temperature and a normal pressure, which is the low vapor pressure material.

For example, the source material may be a material containing a metal element and a halogen element. For example, the metal element may be selected from metal elements such as aluminium (Al), molybdenum (Mo), tungsten (W), hafnium (Hf) and zirconium (Zr). For example, the halogen element may be selected from halogen elements such as fluorine (F), chlorine (Cl), bromine (Br) and iodine (I). As the source material in the solid state at the room temperature and the normal pressure, for example, a material such as AlCl₃, Al₂Cl₆, MoCl₅, WCl₆, HfCl₄, ZrCl₄, MoO₂Cl₂ and MoOCl₄ may be used. Further, as the source material in the liquid state at the room temperature and the normal pressure, for example, a source material of metal elements such as ruthenium (Ru) and lanthanum (La) may be used.

When using such a source material, there may be a problem that a flow rate thereof cannot be stably adjusted by a normal mass flow controller. According to the source gas supply system of the present disclosure, it is possible to stably adjust the flow rate. Further, even when a state of the source material in the tank 313 (for example, an amount or a surface state of the source material) changes, it is possible to adjust the flow rate of the source material and to supply the source material stably. Hereinafter, the source gas supply system is described in detail below.

### <Tank>

The source material is stored inside the tank 313. The tank 313 is configured to vaporize or sublimate the source material to generate the source gas. In the present specification, for convenience of explanation, such a phase change of the source material into a gaseous state will be referred to without distinguishing between vaporization and sublimation, being simply referred to as the source material is "vaporized" unless otherwise specified.

The tank 313 is provided with a heater 317b serving as a second heater. By adjusting a temperature of the tank 313 by the heater 317b, it is possible to control an amount of vaporization of the source material. The temperature of the tank 313 may be changed for each substrate processing.

### <First Gas Pipe>

The gas supply pipe 310 (which corresponds to a first gas pipe 310a of the present disclosure) is connected between the tank 313 and the process chamber 201. The first gas pipe 310a is provided with a flow rate measurer (which is a flow rate measuring structure) 312 and the valve 314a, and is connected to a fourth gas pipe 310d described below. The valve 318 may also be provided between the tank 313 and a connection portion between the first gas pipe 310a and the fourth gas pipe 3 10d. The flow rate measurer 312 is configured to measure a flow rate of the process gas flowing through the first gas pipe 310a. Specifically, as the flow rate measurer 312, a configuration such as a mass flow meter, a differential pressure measurer, an infrared (IR) sensor and a pressure gauge may be used. In the present embodiments, the differential pressure measurer is configured to measure the flow rate using a measurement method based on a pressure difference between two points. When the flow rate measurer 312 is configured with a pressure diameter, the flow rate of the source gas in the process gases is calculated based on a difference between a pressure when the gas is supplied through a path in which the gas flows sequentially through a second gas pipe 3 10b, the tank 313 and the first gas pipe 310a (the second gas pipe 310b → the tank 313 → the first gas pipe 310a) and a pressure when the gas is supplied through a path in which the gas flows sequentially through the second gas pipe 310b, a bypass pipe 319 and the first gas pipe 310a (the second gas pipe 310b → the bypass pipe 319 → the first gas pipe 310a). When the IR sensor is used as the flow rate measurer 312, the flow rate of the source gas is calculated by irradiating a light adjusted to an absorption spectrum specific to the source material and measuring an amount of the light absorbed (or reflected) by the source material.

### <Second Gas Pipe>

The second gas pipe 310b is a pipe through which a carrier gas serving as a first inert gas is supplied to the tank 313. The second gas pipe 310b is connected to the tank 313. The second gas pipe 310b is provided with a first flow rate regulator (which is a first flow rate adjusting structure) 315b, the valve 314b, a first heater 317a and the valve 316. For example, a rare gas such as argon (Ar) gas or nitrogen (N₂) gas may be used as the first inert gas. The first inert gas promotes the vaporization of the source material. By adjusting a supply amount of the first inert gas or a temperature of the first inert gas, it is possible to control the amount of the vaporization of the source material. In the present embodiments, for example, the first heater 317a is configured as a gas heating structure with a heater provided therein. Further, in the present disclosure, the first inert gas may also be referred to as a "heated carrier gas".

### <Third Gas Pipe>

A third gas pipe 310c is a pipe through which a carrier gas serving as a second inert gas is supplied to the tank 313. The third gas pipe 310c is connected to the tank 313. The third gas pipe 310c is provided with a second flow rate regulator (which is a second flow rate adjusting structure) 315c and the valve 314c. For example, a rare gas such as argon (Ar) gas or nitrogen (N₂) gas may be used as the second inert gas. The second inert gas promotes the vaporization of the source material. The second inert gas is used to adjust the temperature and a flow rate of the first inert gas. Further, in the present disclosure, the second inert gas may also be referred to as an "auxiliary gas".

### <Fourth Gas Pipe>

The fourth gas pipe 310d is a pipe through which a dilution gas serving as a third inert gas is supplied to the first gas pipe 310a. The fourth gas pipe 310d is connected to the first gas pipe 310a. The fourth gas pipe 3 10d is provided with a third flow rate regulator (which is a third flow rate adjusting structure) 315d and the valve 314d.

In the present disclosure, the source gas supply system 300 is constituted by at least the first gas pipe 310a, the flow rate measurer 312, the tank 313, the second gas pipe 310b, the first heater 317a, the valves 314a and 314b and the first flow rate regulator 315b. The source gas supply system 300 may further include other components shown in FIG. 3.

### <Bypass Pipe>

The bypass pipe 319 shown by a dashed line in FIG. 3 may be provided. The bypass pipe 319 is a gas pipe directly connecting the first gas pipe 310a and the second gas pipe 310b. Further, the bypass pipe 319 is provided with the valve 320. By opening and closing the valves 320, 316 and 318, it is possible to form the gas path of "the second gas pipe 310b → the tank 313 → the first gas pipe 310a" and the gas path of "the second gas pipe 310b → the first gas pipe 310a".

### <Reactive Gas Supply System>

### <Reactive Gas>

The reactive gas of the present disclosure is a reactive gas (reactant) reacting with the source gas. As the reactive gas, for example, a hydrogen-containing gas (reducing gas) may used. As the hydrogen-containing gas, for example, a gas such as hydrogen (H₂) gas and deuterium gas may used. A nitrogen-containing gas (nitriding gas) may also be used as the reactive gas. As the nitrogen-containing gas, for example, a gas such as ammonia (NH₃) gas and hydrazine (N₂H₄) gas may be used. An oxygen-containing gas (oxidizing gas) may also be used as the reactive gas. As oxygen-containing gas, for example, a gas such as oxygen (O₂) gas, ozone (O₃) gas, water vapor (H₂O) and hydrogen peroxide (H₂O₂) gas may be used.

### <Fifth Gas Pipe>

The fifth gas pipe 320 (320a) is provided with a fourth flow rate regulator (which is a fourth flow rate adjusting structure) 325a and the valve 324a. The fifth gas pipe 320a is connected to the process chamber 201.

### <Sixth Gas Pipe>

A sixth gas pipe 320b is a pipe through which a dilution gas serving as a fourth inert gas is supplied to the fifth gas pipe 320a. The sixth gas pipe 320b is provided with a fifth flow rate regulator (which is a fifth flow rate adjusting structure) 325b and the valve 324b.

In the present disclosure, the reactive gas supply system 400 is constituted by at least the fifth gas pipe 320a, the fourth flow rate regulator 325a and the valve 324a. The reactive gas supply system 400 may further include other components shown in FIG. 3.

Further, in the present disclosure, each of the first flow rate regulator 315b, the second flow rate regulator 315c, the third flow rate regulator 315d, the fourth flow rate regulator 325a and the fifth flow rate regulator 325b is configured a mass flow controller (MFC), for example.

### <Controller>

The controller 121 corresponding to the control structure in the present disclosure is configured to be capable of calculating the flow rate of the source gas in the process gases flowing through the first gas pipe 3 10a based on information such as a measurement signal from the flow rate measurer 312, a set value of the first flow rate regulator 315b, physical property data of the source gas and physical property data of the inert gas. Further, in addition to the information exemplified above, the controller 121 may be further configured to be capable of calculating the flow rate of the source gas in the process gases based on information such as a set value of the second flow rate regulator 315c and a set value of the third flow rate regulator 315d.

### (3) Substrate Processing

Subsequently, as a substrate processing, a manufacturing process of a semiconductor device using the substrate processing apparatus 10 according to the present embodiments will be described. In the following, an overview of the manufacturing process of the semiconductor device will be first described, and a part of the manufacturing process of the semiconductor device in accordance with a source gas supply method using the source gas supply system 300 will be described separately later in "(4) Source Gas Supply Method".

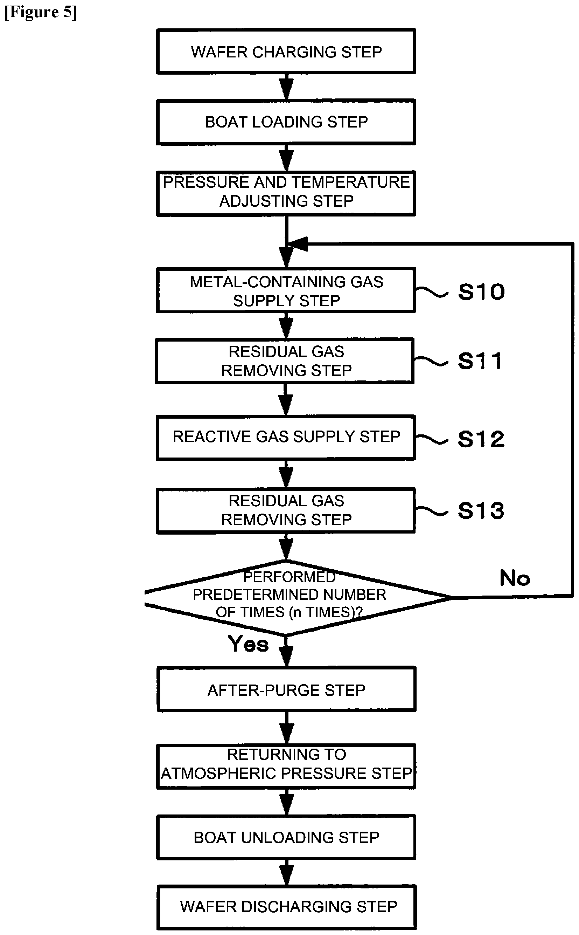

Hereinafter, as a part of the manufacturing process of the semiconductor device, an example of the substrate processing of forming a film containing molybdenum (Mo) (hereinafter, also referred to as a "Mo-containing film") on the wafer 200 will be described with reference to FIG. 5. For example, the Mo-containing film is used as a control gate electrode of a 3D NAND. In the following description, the operations of components constituting the substrate processing apparatus 10 are controlled by the controller 121.

In the present specification, the term "wafer" may refer to "a wafer itself', or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself', or may refer to "a surface of a predetermined layer or a film formed on a wafer". In the present specification, the term "substrate" and "wafer" may be used as substantially the same meaning.

### <Wafer Charging Step>

The wafers 200 are charged (transferred) into the boat 217 (wafer charging step). After the boat 217 is charged with the wafers 200, as shown in FIG. 1, the boat 217 supporting the wafers 200 is elevated by the boat elevator 115 and loaded (transferred) into the process chamber 201 to be accommodated in the process vessel (boat loading step). In such a state, the seal cap 219 seals a lower end opening of the outer tube 203 via the O-ring 220.

### <Pressure Adjusting Step and Temperature Adjusting Step>

The vacuum pump 246 vacuum-exhausts the inner atmosphere of the process chamber 201 such that the inner pressure of the process chamber 201 (that is, a pressure in a space in which the wafers 200 are accommodated) reaches and is maintained at a desired pressure (vacuum degree). Meanwhile, the inner pressure of the process chamber 201 is measured by the pressure sensor 245, and the APC valve 243 is feedback-controlled based on pressure information measured by the pressure sensor 245 (pressure adjusting step). Further, the vacuum pump 246 continuously vacuum-exhausts the inner atmosphere of the process chamber 201 until at least a processing of the wafer 200 is completed.

In addition, the heater 207 heats the process chamber 201 such that the inner temperature of the process chamber 201 reaches and is maintained at a desired temperature. Meanwhile, the amount of the current supplied to the heater 207 is feedback-controlled based on the temperature information detected by the temperature sensor 263 such that the desired temperature distribution of the inner temperature of the process chamber 201 is obtained (temperature adjusting step). In the following, for example, a temperature of the heater 207 is set such that a temperature of the wafer 200 reaches and is maintained at a predetermined temperature within a range equal to or higher than 300 °C and equal to or lower than 600 °C. Further, the heater 207 continuously heats the process chamber 201 until at least the processing of the wafer 200 is completed.

### <Step S10>

### <Metal-containing Gas Supply Step>

The valve 314a is opened to supply the inert gas into the tank 313. Further, the valve 316 is opened to supply the metal-containing gas (serving as the source gas) into the gas supply pipe 310 from the tank 313. A flow rate of the metal-containing gas is adjusted by the flow rate of the first inert gas adjusted by MFC 315b. The metal-containing gas whose flow rate is adjusted is then supplied into the process chamber 201 through the gas supply holes 410a of the nozzle 410, and is exhausted through the exhaust pipe 231. Thereby, the metal-containing gas is supplied to the wafers 200. In the present step, in parallel with a supply of the metal-containing gas, the valve 314d may be opened to supply the third inert gas into the gas supply pipe 310d. A flow rate of the third inert gas supplied into the gas supply pipe 310d is adjusted by the MFC 315d. The third inert gas whose flow rate is adjusted is then supplied into the process chamber 201 together with the metal-containing gas, and is exhausted through the exhaust pipe 231. In the present step, in order to prevent the metal-containing gas from entering the nozzle 420, the valve 324b may be opened to supply the inert gas into the gas supply pipes 320b and 320 (320a). The inert gas is then supplied into the process chamber 201 through the gas supply pipe 320 and the nozzle 420, and is exhausted through the exhaust pipe 231. The first inert gas acts mainly as the carrier gas, and the third inert gas acts mainly as the dilution gas used so as to adjust a concentration of the source gas in the process gases. The first inert gas acts mainly as the carrier gas, but may also be used so as to adjust the concentration of the source gas in the process gases. By using both the first inert gas and the third inert gas, it is possible to improve an accuracy of adjusting the concentration of the source gas and an accuracy of transferring the source gas.

In the present step, for example, the APC valve 243 is appropriately adjusted (or controlled) such that the inner pressure of the process chamber 201 can be set to a pressure within a range from 1 Pa to 3990 Pa. For example, the inner pressure of the process chamber 201 is set to 1000 Pa by adjusting the APC valve 243. For example, a supply flow rate of the inert gas controlled by the MFC 310b can be set to a flow rate within a range from 0.1 slm to 1.0 slm, preferably from 0.1 slm to 0.5 slm. For example, a supply flow rate of the inert gas controlled by the MFC 310d can be set to a flow rate within a range from 0.1 slm to 20 slm. In the present specification, a notation of a numerical range such as "from 1 Pa to 3990 Pa" means that a lower limit and an upper limit are included in the numerical range. Therefore, for example, the numerical range "from 1 Pa to 3990 Pa" means a range equal to or higher than 1 Pa and equal to or lower than 3990 Pa. The same also applies to other numerical ranges described herein.

In the present step, the metal-containing gas and the inert gas are supplied into the process chamber 201 without supplying other gases thereto. According to the present embodiments, as the metal-containing gas, for example, the gas containing molybdenum (Mo) (hereinafter, also referred to as "Mo-containing gas") may be used. As the Mo-containing gas, for example, a gas such as MoCl₅ gas, MoO₂Cl₂ gas and MoOCl₄ gas may be used. By supplying the metal-containing gas, a metal-containing layer is formed on the wafer 200 (that is, on an aluminium oxide (AlO) film serving as a base film on the surface of the wafer 200). When one of the MoO₂Cl₂ gas and the MoOCl₄ gas is used as the metal-containing gas, the metal-containing layer includes a molybdenum-containing layer (hereinafter, also referred to as a "Mo-containing layer"). The Mo-containing layer may refer to a molybdenum layer containing chlorine (Cl) or oxygen (O), may refer to an adsorption layer of MoO₂Cl₂ (or MoOCl₄) or may refer to both of the molybdenum layer containing chlorine (Cl) or oxygen (O) and the adsorption layer of the MoO₂Cl₂ (or MoOCl₄). Further, the Mo-containing layer may refer to a film containing molybdenum (Mo) as a primary element (or main element). That is, the Mo-containing layer may contain an element such as chlorine (Cl), oxygen (O) and hydrogen (H) in addition to molybdenum (Mo).

Herein, the source material in the tank 313 is heated in advance by the heater 317b such that the source material reaches a temperature to be vaporized. However, in the following cases (A) to (E), for example, the temperature of the source material in the tank 313 may change, and a predetermined flow rate of the source material may not be obtained: (A) a case where the supply amount of the first inert gas increases; (B) a case where the supply amount of the first inert gas decreases; (C) a case where an amount of the source material in the tank 313 is less than the predetermined flow rate; (D) a case where a particle size of the source material in the tank 313 is small; and (E) a case where the particle size of the source material in the tank 313 is large. When such cases occur, the amount of vaporization of the source material may increase or decrease, the flow rate of the source material in the process gases and the concentration of the source material may change, and characteristics of the film formed on the wafer 200 may differ for each of the wafers 200 or each layer.

In order to reduce an occurrence of such problems, for example, the following adjusting operations may be performed.

### <Step S10A (Flow Rate Adjusting Operation for First Inert Gas)>

The flow rate of the first inert gas is adjusted. By adjusting the flow rate of the first inert gas, it is possible to adjust the amount of vaporization of the source material, and it is also possible to adjust the flow rate of the source gas. For example, as the flow rate of the source gas in the process gases decreases, the flow rate of the first inert gas is increased. Thereby, it is possible to increase the flow rate of the source gas in the process gases. On the other hand, when the flow rate of the source gas increases, the flow rate of the first inert gas is decreased. In addition, in order to suppress fluctuations in a total flow rate of the process gases by adjusting the flow rate of the first inert gas, it is preferable to adjust the flow rate of the third inert gas serving as the dilution gas.

### <Step S10B (Temperature Adjusting Operation for First Inert Gas)>

The temperature of the first inert gas is adjusted. By adjusting the temperature of the first inert gas, it is possible to adjust the amount of the vaporization of the source material, and it is also possible to adjust the flow rate of the source gas. For example, as the flow rate of the source gas in the process gases decreases, the temperature of the first inert gas is increased. Thereby, by increasing the amount of vaporization of the source material in the process gases, it is possible to increase the flow rate of the source gas in the process gases. On the other hand, when the flow rate of the source gas increases, the temperature of the first inert gas is decreased. In the present step, the temperature of the first inert gas is adjusted by one or both of the first heater 317a and the second heater 317b. For example, the first heater 317a is configured as a heat exchanger, and the second heater 317b is configured to heat the tank 313 with a resistance heating type heater. Since the first heater 317a can directly heat the first inert gas, it is possible to easily adjust the temperature of the first inert gas as compared with a case where the second heater 317b is used. In addition, the second heater 317b may affect the temperature of the source material because the second heater 317b also changes the temperature of the tank 313. Therefore, it is preferable to maintain a temperature of the second heater 317b constant while adjusting a temperature of the first heater 317a. More preferably, the temperature of the first heater 317a is set to a temperature higher than the temperature of the second heater 317b. By setting such a temperature relationship, even when the temperature of the first inert gas heated by the first heater 317a decreases until the first inert gas reaches the tank 313, it is likely to affect the temperature of the source material in the tank 313.

Further, the second inert gas may be supplied so as to adjust the temperature of the first inert gas. By maintaining the temperature of the first heater 317a at a predetermined temperature and by mixing and supplying the first inert gas (which is heated) and the second inert gas (which is not heated) to the tank 313, the temperature of the first inert gas is adjusted. By adjusting the temperature of the first inert gas in a manner described above, it is possible to shorten a temperature adjustment time. Even though the temperature of the first inert gas can be adjusted by changing a temperature setting of the first heater 317a, there is a time lag from a change in the temperature setting to a change in the temperature of the first inert gas. However, by supplying the second inert gas (which is not heated) to the first inert gas (which is heated) in a manner described above, it is possible to adjust the temperature of the first inert gas in a short time. By adjusting the flow rate of the second inert gas or a flow rate ratio of the first inert gas and the second inert gas, it is possible to adjust the temperature of the first inert gas by using the second inert gas. For example, by maintaining the flow rate of the first inert gas constant and by increasing the flow rate of the second inert gas, it is possible to decrease (or lower) the temperature of the inert gas supplied to the tank 313. On the other hand, by maintaining the flow rate of the first inert gas constant and by decreasing the flow rate of the second inert gas, it is possible to increase (or elevate) the temperature of the inert gas supplied to the tank 313. Further, when it is desired to maintain a total amount of the inert gas supplied to the tank 313 constant, the flow rate of the second inert gas may be increased while decreasing the flow rate of the first inert gas, or the flow rate of the second inert gas may be decreased while increasing the flow rate of the first inert gas. By maintaining the total amount of the inert gas supplied to the tank 313 constant, it is possible to suppress a change in the flow rate (concentration) of the source gas in the process gases supplied to the process chamber 201.

### <Step S11 (First Purge Step)>

### <Residual Gas Removing Step>

After a predetermined time (for example, from 0.01 second to 10 seconds) has elapsed from the supply of the metal-containing gas, the valve 318 is closed to stop the supply of the metal-containing gas. That is, for example, a supply time (which is a time duration) of supplying the metal-containing gas to the wafer 200 is set to a time within a range from 0.01 second to 10 seconds. In the present step, with the APC valve 243 of the exhaust pipe 231 open, the vacuum pump 246 vacuum-exhausts the inner atmosphere of the process chamber 201 to remove a residual gas remaining in the process chamber 201 such as the metal-containing gas which did not react or which contributed to a formation of the metal-containing layer from the process chamber 201. That is, the process chamber 201 is purged. In the present step, by maintaining the valves 314a and 324b open, the inert gas is continuously supplied into the process chamber 201. The inert gas serves as a purge gas, which improves an efficiency of removing the residual gas remaining in the process chamber 201 such as the metal-containing gas which did not react or which contributed to the formation of the metal-containing layer out of the process chamber 201.

### <Reactive Gas Supply Step S12>

After the residual gas remaining in the process chamber 201 is removed, the valve 324a is opened to supply the reactive gas into the gas supply pipe 320 (320a). A flow rate of the reactive gas supplied into the gas supply pipe 320 is adjusted by the MFC 325a. The reactive gas whose flow rate is adjusted is then supplied into the process chamber 201 through the gas supply holes 420a of the nozzle 420, and is exhausted through the exhaust pipe 231. Thereby, in the present step, the reactive gas is supplied to the wafer 200. In the present step, in parallel with a supply of the reactive gas, the valve 324b may be opened to supply the inert gas into the gas supply pipe 320b. The flow rate of the inert gas supplied into the gas supply pipe 320b is adjusted by the MFC 325b. The inert gas whose flow rate is adjusted is then supplied into the process chamber 201 together with the reactive gas, and is exhausted through the exhaust pipe 231. In the present step, in order to prevent the reactive gas from entering the nozzle 410, the valves 314a and 314d may be opened to supply the inert gas into the gas supply pipe 310a. The inert gas is then supplied into the process chamber 201 through the gas supply pipe 310 and the nozzle 410, and is exhausted through the exhaust pipe 231. In the present step, as the reactive gas, for example, a reducing gas is used.

In the present step, for example, the APC valve 243 is appropriately adjusted (or controlled) such that the inner pressure of the process chamber 201 can be set to a pressure within a range from 1 Pa to 3990 Pa. For example, the inner pressure of the process chamber 201 is set to 2000 Pa by adjusting the APC valve 243. For example, a supply flow rate of the reducing gas controlled by the MFC 325a can be set to a flow rate within a range from 1 slm to 50 slm, preferably from 15 slm to 30 slm. For example, the supply flow rate of the inert gas controlled by each of the MFCs 325b and 315d can be set to a flow rate within a range from 0.1 slm to 30 slm. For example, a supply time (which is a time duration) of supplying the reducing gas to the wafer 200 is set to a time within a range from 0.01 second to 120 seconds.

In the present step, the reducing gas alone is supplied or the reducing gas and the inert gas are supplied into the process chamber 201 without supplying other gases thereto. According to the present embodiments, as the reducing gas, for example, a gas such as the hydrogen (H₂) gas, the deuterium (D₂) gas and a gas containing activated hydrogen may be used. When the H₂ gas is used as the reducing gas, a substitution reaction occurs between the H₂ gas and at least a portion of the Mo-containing layer formed on the wafer 200 in the step S10. That is, oxygen (O) or chlorine (Cl) in the Mo-containing layer reacts with H₂, desorbs from the Mo-containing layer, and is discharged from the process chamber 201 as reaction by-products such as water vapor (H₂O), hydrogen chloride (HCl) and chlorine (Cl₂). Thereby, a metal layer (that is, a molybdenum (Mo) layer) containing molybdenum (Mo) and substantially free of chlorine (Cl) and oxygen (O) is formed on the wafer 200.

### <Step S13 (Second Purge Step)>

### <Residual Gas Removing Step>

After the metal layer is formed, the valve 324a is closed to stop the supply of the reactive gas.

Then, a residual gas remaining in the process chamber 201 such as the reactive gas which did not react or which contributed to a formation of the metal layer and the reaction by-products are removed out of the process chamber 201 in substantially the same manners as in the step S11 (first purge step). That is, the process chamber 201 is purged.

### <Performing a Predetermined Number of Times>

By performing a cycle (in which the step S10 through the step S13 described above are sequentially performed in this order) at least once (that is, a predetermined number of times (n times, where n is an integer equal to or greater than 1)), the metal-containing film of a predetermined thickness (for example, from 0.5 nm to 20.0 nm) is formed on the wafer 200. It is preferable that the cycle described above is repeatedly performed a plurality number of times. Further, each of the step S10 through the step S13 may be performed at least once.

In addition, the step S10A (the flow rate adjusting operation for the first inert gas) and the step S10B (the temperature adjusting operation for the first inert gas), which are described above, are performed before the step S10 described above. Alternatively, the step S10A and the step S10B may be performed between the steps S10 and S13. Alternatively, the step S10A and the step S10B may be performed while the steps S10 to S13 are repeatedly performed the plurality number of times. By performing the step S10A and the step S10B during the processing of the wafer 200, it is possible to uniformize the characteristics of each layer of the film formed on the wafer 200.

### <After-purge Step and Returning to Atmospheric Pressure Step>

The inert gas is supplied into the process chamber 201 through each of the gas supply pipes 310a and 320a, and is exhausted through the exhaust pipe 231. The inert gas serves as the purge gas, and thereby the inner atmosphere of the process chamber 201 is purged with the inert gas. Thus, the residual gas remaining in the process chamber 201 or the reaction by-products remaining in the process chamber 201 is removed from the process chamber 201 (after-purge step). Thereafter, the inner atmosphere of the process chamber 201 is replaced with the inert gas (substitution by inert gas), and the inner pressure of the process chamber 201 is returned to the normal pressure (atmospheric pressure) (returning to atmospheric pressure step).

### <Wafer Discharging Step>

Thereafter, the seal cap 219 is lowered by the boat elevator 115 and the lower end opening of the outer tube 203 is opened. The boat 217 with the wafers (which are processed) 200 charged therein is unloaded out of the outer tube 203 through the lower end opening of the outer tube 203 (boat unloading step). Then, the wafers (which are processed) 200 are discharged (transferred) out of the boat 217 (wafer discharging step).

### (4) Source Gas Supply Method

Subsequently, the source gas supply method performed using the source gas supply system 300 according to the present embodiments will be specifically described with reference to FIG. 3. The source gas supply method is performed while the step of supplying the metal-containing gas serving as the source gas to the process chamber 201 (which serves as a reaction chamber) is being performed.

First, the first source gas is generated by vaporizing the source material in the tank 313. Subsequently, the first inert gas is supplied to the tank 313 to promote the vaporization of the source material. That is, a second source gas is generated by mixing the first source gas and the first inert gas. Then, the second source gas flows to a downstream side of the tank 313.

Subsequently, the third inert gas is supplied to the gas supply pipe 310d to dilute the second source gas. In the present embodiments, the first inert gas and the third inert gas are the same type of gas, such as argon (Ar) gas and the N₂ gas. That is, a third source gas is generated by mixing the second source gas and the third inert gas. The third source gas generated in a manner described above flows to the flow rate measurer 312. Alternatively, the third inert gas may not be supplied.

Subsequently, the flow rate is measured by the flow rate measurer 312. A flow rate value (flow rate data) measured by the flow rate measurer 312 is input to the controller 121. The controller 121 calculates source gas data based on the flow rate value measured by the flow rate measurer 312 and at least one among a set flow rate of the first flow rate regulator 315b, a physical property value of the source material, a physical property value of the first inert gas and the like. In the present embodiments, for example, the term "source gas data" may refer to at least one among the flow rate of the source gas in the third source gas flowing through the first gas pipe 310a and the concentration of the source gas and the like.

Subsequently, based on the source gas data calculated in a manner described above, at least one among the following feed-back controls (operations) (A) to (E) may be performed such that the flow rate data of the source gas can be set to a predetermined value (target value). Alternatively, the flow rate data of the source gas may be controlled to be within a predetermined range, not to the predetermined value mentioned above. Further, a combination of two or more of the operations (A) to (E) may be performed.

### (A) Flow Rate Adjusting Operation for First Inert Gas

The flow rate of the first inert gas is adjusted by the first flow rate regulator 315b. The flow rate of the first inert gas is adjusted by adjusting a set value of flow rate of the first flow rate regulator 315b. For example, by increasing the flow rate of the first inert gas, it is possible to increase the amount of the vaporization of the source material in the tank 313. By increasing the amount of the vaporization, it is possible to increase the flow rate of the source material. On the other hand, by decreasing the flow rate of the first inert gas, it is possible to decrease the amount of the vaporization of the source material in the tank 313.By decreasing the amount of the vaporization, it is possible to decrease the flow rate of the source material.

### (B) Temperature Adjusting Operation for First Inert Gas

The temperature of the first inert gas is adjusted by the first heater 317a. By increasing the temperature of the first heater 317a, it is possible to increase the temperature of the first inert gas. By increasing the temperature of the first inert gas, it is possible to increase the temperature of the source material in the tank 313. As a result, it is possible to increase the amount of the vaporization of the source material. Further, by decreasing the temperature of the first heater 317a, it is possible to decrease the temperature of the first inert gas. By decreasing the temperature of the first inert gas, it is possible to decrease the amount of the vaporization of the source material in the tank 313. Since the first inert gas comes into direct contact with the source material in the tank 313, by adjusting the temperature of the first inert gas, it is possible to adjust the amount of the vaporization of the source material in a relatively short time.

### (C) Temperature Adjusting Operation for Tank 313 (Source Material)

The temperature of the tank 313 (that is, the source material in the tank 313) is adjusted by the second heater 317b. By increasing the temperature of the second heater 317b, it is possible to increase the temperature of the source material in the tank 313. As a result, it is possible to promote the vaporization of the source material. On the other hand, by decreasing the temperature of the second heater 317b, it is possible to decrease the temperature of the source material in the tank 313, and it is also possible to decrease (reduce) the amount of the vaporization of the source material. In addition, since the heat of the second heater 317b is transferred to the source material via the tank 313, it takes a relatively long time for the amount of the vaporization of the source material to change after the temperature of the second heater 317b is changed. Therefore, it is preferable to adjust the temperature of the tank 313 while the wafer 200 is not being processed.

### (D) Flow Rate Adjusting Operation for Second Inert Gas

The flow rate of the second inert gas is adjusted by the second flow rate regulator 315c. By adjusting the set value of the second flow rate regulator 315c, it is possible to adjust the flow rate of the second inert gas. By supplying the second inert gas, it is possible to adjust the temperature of the inert gas supplied to the tank 313. In particular, by supplying the first inert gas (which is heated) and the second inert gas (which is not heated) to the tank 313, it is possible to adjust the temperature of the inert gas supplied to the tank 313. By adjusting the temperature of the first inert gas, the flow rate of the first inert gas and the flow rate of the second inert gas, it is possible to adjust the temperature of the inert gas supplied to the tank 313. While the temperature of the first inert gas can be adjusted by the first heater 317a, the temperature of the first heater 317a may not be changed instantly. For example, there may be a case where the temperature of the first inert gas is increased too much by increasing the temperature of the first heater 317a, and it is desired to instantly decrease the temperature of the first inert gas. In such a case, it takes time until the temperature of the first inert gas decreases by lowering the temperature setting of the first heater 317a. In such a case, by supplying the second inert gas, it is possible to mix the first inert gas (whose temperature is high) with the second inert gas (whose temperature is at the room temperature, for example). In a manner described above, it is possible to adjust the temperature of the inert gas supplied to tank 313.

### (E) Flow Rate Adjusting Operation for Third Inert Gas

When performing the operations (A) to (D) mentioned above, a ratio of the flow rate of the source gas flowing through the first gas pipe 310a to the flow rate of the inert gas flowing through the first gas pipe 310a (that is, a concentration of the source gas) may deviate from a range used for the processing of the wafer 200. In such a case, by adjusting the flow rate of the third inert gas, it is possible to adjust the flow rate of the source gas (that is, the concentration of the source gas) used for the processing of the wafer 200. For example, when the flow rate of the first inert gas is increased, the concentration of the source gas may decrease. In such a case, by decreasing the flow rate of the third inert gas, it is possible to adjust the concentration of the source gas to be within a predetermined range.

### (5) Other Embodiments of Present Disclosure

The technique of the present disclosure is described in detail by way of the embodiments mentioned above. However, the technique of the present disclosure is not limited thereto. The technique of the present disclosure may be modified in various ways without departing from the scope thereof.

For example, the embodiments mentioned above are described by way of an example in which the Mo-containing gas is used. However, the technique of the present disclosure is not limited thereto. For example, a gas containing at least one among the metal elements such as aluminium (Al), molybdenum (Mo), tungsten (W), hafnium (Hf) and zirconium (Zr) may be used.

For example, the embodiments mentioned above are described by way of an example in which the H₂ gas is used as the reducing gas. However, the technique of the present disclosure is not limited thereto.

For example, the embodiments mentioned above are described by way of an example in which a batch and vertical type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of simultaneously processing one or several substrates is used to form the film. Further, for example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

The process procedures and the process conditions of each process using the substrate processing apparatuses exemplified above may be substantially the same as those of the embodiments or modified examples mentioned above. Even in such a case, it is possible to obtain substantially the same effects as in the embodiments or the modified examples mentioned above.

Further, the embodiments and the modified examples mentioned above may be appropriately combined. The process procedures and the process conditions of each combination thereof may be substantially the same as those of the embodiments or the modified examples mentioned above.

**[Description of Reference Numerals]**

| | | | |
|---|---|---|---|
| 10 | Substrate processing apparatus | 12 | Gas supply system |
| 313 | Tank | 121 | Controller (control structure) |
| 200 | Wafer (substrate) | | |
| 201 | Process chamber (reaction chamber) | 310 | First gas pipe |

## Claims

1. A substrate processing apparatus comprising:
a process vessel in which a substrate is accommodated;
a first gas pipe through which a process gas is supplied to the process vessel;
a flow rate measurer provided at the first gas pipe and configured to measure a flow rate of the process gas flowing through the first gas pipe;
a second gas pipe connected to the first gas pipe and through which a first inert gas is supplied to a tank configured to store a source material of the process gas;
a first flow rate regulator provided at the second gas pipe and configured to adjust a flow rate of the first inert gas;
a first heater configured to adjust a temperature of the first inert gas; and
a controller configured to be capable of controlling the first flow rate regulator and the first heater to supply the process gas to the substrate in the process vessel by adjusting one or both of the flow rate of the first inert gas and the temperature of the first inert gas such that the flow rate of the process gas is adjusted to be a predetermined flow rate based on flow rate data of the process gas measured by the flow rate measurer.

2. The substrate processing apparatus of claim 1, wherein the first heater is provided at the second gas pipe.

3. The substrate processing apparatus of claim 2, further comprising:
a third gas pipe through a second inert gas is supplied to the tank; and
a second flow rate regulator provided at the third gas pipe and configured to adjust a flow rate of the second inert gas,
wherein the controller is further configured to be capable of controlling a set value of a flow rate of the second flow rate regulator.

4. The substrate processing apparatus of any one of claims 1 through 3, wherein the controller is further configured to be capable of controlling the first heater to increase the temperature of the first inert gas when a flow rate of the source material in the process gas is less than a target value.

5. The substrate processing apparatus of claim 3, wherein the controller is further configured to be capable of controlling the first flow rate regulator and the second flow rate regulator to increase both of the flow rate of the first inert gas and the flow rate of the second inert gas when a flow rate of the source material in the process gas is less than a target value.

6. The substrate processing apparatus of claim 3, wherein the controller is further configured to be capable of controlling the first heater to increase the temperature of the first inert gas in the tank and controlling the second flow rate regulator to decrease the flow rate of the second inert gas when a flow rate of the source material in the process gas is less than a target value.

7. The substrate processing apparatus of any one of claims 1 through 3, wherein the controller is further configured to be capable of controlling the first flow rate regulator to decrease the flow rate of the first inert gas supplied to the tank when a flow rate of the source material in the process gas is greater than a target value.

8. The substrate processing apparatus of any one of claims 1 through 3, wherein the controller is further configured to be capable of controlling the first heater to decrease the temperature of the first inert gas in the tank when a flow rate of the source material in the process gas is greater than a target value.

9. The substrate processing apparatus of any one of claims 1 through 3, wherein the controller is further configured to be capable of controlling the second flow rate regulator to increase the flow rate of the second inert gas when a flow rate of the source material in the process gas is greater than a target value.

10. The substrate processing apparatus of any one of claims 1 through 3, wherein the controller is further configured to be capable of controlling a temperature of the first heater while the substrate is being processed in the process vessel.

11. The substrate processing apparatus of claim 3, wherein the controller is further configured to be capable of controlling the second flow rate regulator to adjust the temperature of the first inert gas in the tank by adjusting the flow rate of the second inert gas without changing a temperature setting of the first heater while the substrate is being processed in the process vessel.

12. The substrate processing apparatus of any one of claims 1 through 3, further comprising
a second heater configured to heat the tank,
wherein the controller is further configured to be capable of setting the temperature of the first heater to be higher than a temperature of the second heater.

13. The substrate processing apparatus of claim 12, wherein the controller is further configured to be capable of adjusting the temperature of the second heater while the substrate is not being processed in the process vessel.

14. The substrate processing apparatus of claim 12, wherein the controller is further configured to be capable of controlling the temperature of the first heater in accordance with the temperature of the second heater.

15. A gas supply system comprising:
a first gas pipe through which a process gas is supplied to a process vessel in which a substrate is accommodated;
a flow rate measurer provided at the first gas pipe and configured to measure a flow rate of the process gas flowing through the first gas pipe;
a second gas pipe connected to the first gas pipe and through which a first inert gas is supplied to a tank configured to store a source material of the process gas;
a first flow rate regulator provided at the second gas pipe and configured to adjust a flow rate of the first inert gas;
a first heater configured to adjust a temperature of the first inert gas; and
a controller configured to be capable of controlling the first flow rate regulator and the first heater such that the flow rate of the process gas is adjusted to be a predetermined flow rate based on flow rate data of the process gas measured by the flow rate measurer.

16. A substrate processing method comprising:
supplying a first inert gas to a tank configured to store a source material to vaporize the source material;
supplying a process gas containing the vaporized source material from the tank to a flow rate measurer to measure a flow rate of the process gas and generating flow rate data; and
supplying the process gas to a substrate in a process vessel by adjusting one or both of a flow rate of the first inert gas and a temperature of the first inert gas such that the flow rate of the process gas is adjusted to be a predetermined flow rate based on the flow rate data of the process gas.

17. A method of manufacturing a semiconductor device, comprising
supplying a first inert gas to a tank configured to store a source material to vaporize the source material;
supplying a process gas containing the vaporized source material from the tank to a flow rate measurer to measure a flow rate of the process gas and generating flow rate data; and
supplying the process gas to a substrate in a process vessel by adjusting one or both of a flow rate of the first inert gas and a temperature of the first inert gas such that the flow rate of the process gas is adjusted to be a predetermined flow rate based on the flow rate data of the process gas.

18. A program that causes a substrate processing apparatus, by a computer, to perform:
supplying a first inert gas to a tank configured to store a source material to vaporize the source material;
supplying a process gas containing the vaporized source material from the tank to a flow rate measurer to measure a flow rate of the process gas and generating flow rate data; and
supplying the process gas to a substrate in a process vessel by adjusting one or both of a flow rate of the first inert gas and a temperature of the first inert gas such that the flow rate of the process gas is adjusted to be a predetermined flow rate based on the flow rate data of the process gas.
